(19) Europäisches Patentamt / European Patent Office / Office européen des brevets

(11) **EP 2 701 249 A2**

(12) **EUROPEAN PATENT APPLICATION**

(43) Date of publication:
**26.02.2014 Bulletin 2014/09**

(21) Application number: **13177953.0**

(22) Date of filing: **25.07.2013**

(51) Int Cl.:
*H01S 5/026* (2006.01)   *H01S 5/062* (2006.01)
*H01S 5/183* (2006.01)   *H01S 5/40* (2006.01)
*H01S 5/42* (2006.01)   *H01S 5/02* (2006.01)

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **23.08.2012 JP 2012184159**
**18.07.2013 JP 2013149676**

(71) Applicant: **Canon Kabushiki Kaisha**
**Tokyo 146-8501 (JP)**

(72) Inventors:
• **Inao, Yasuhisa**
**Tokyo 146-8501 (JP)**
• **Uchida, Mamoru**
**Tokyo 146-8501 (JP)**

(74) Representative: **TBK**
**Bavariaring 4-6**
**80336 München (DE)**

(54) **Variable wavelength surface emitting laser**

(57)   A surface emitting laser includes a first laser, and a second laser, wherein each of the first laser and the second laser includes a light resonant cavity including a pair of reflecting mirrors (110-1,11a-2,102) and a semiconductor layer (104) configured to emit light and arranged inside the light resonant cavity, an oscillation wavelength of light can be varied by displacing a location of the reflecting mirror in a thickness direction of the semiconductor layer, the semiconductor layer is shared by the first laser and the second laser, the first laser has a resonant cavity length for oscillating with (n + 1)th order (n is an integer of 1 or more) of a longitudinal mode, the second laser has a resonant cavity length for oscillating with nth order of a longitudinal mode, and respective wavelength bands of light oscillated by the first laser the second laser are different. The monolithic array of VCSEL emitting at different wavelengths sharing the bottom mirror (102) and spacer layers (103,105) in the cavity. The cavity length can be adjusted by the dielectric mirrors (110-1,110-2) being provided on a membrane (111) with an air-gap (125).

**FIG.1**

**Description**

BACKGROUND OF THE INVENTION

Field of the Invention

The present invention relates to a surface emitting laser of which an oscillation wavelength of light can be varied.

Description of the Related Art

Various laser sources that can vary an oscillation wavelength have been utilized in fields of communication networks and inspection devices.

High-speed switching of a wavelength is desired in the field of communication networks, as well as a high-speed and broad wavelength sweeping in the field of inspection devices.

Applications of a variable wavelength (sweeping) light source for inspection devices include a laser spectroscope, a dispersion measuring instrument, a film thickness gauge, and a swept source optical coherence tomography (SS-OCT) device.

An optical coherence tomography is an imaging technique for imaging a tomogram of an object using optical coherence. In recent years, many researches on the optical coherence tomography have been performed in the medical field since the technique provides a spatial resolution of the order of micron and non-invasive treatment.

SS-OCT is expected that, since SS-OCT uses a spectral interference for obtaining depth information and does not use a spectroscope, the loss of light amount is little and an image can be captured at a high SN ratio.

Further, it is known that the resolution of a tomogram imaged by SS-OCT is determined by a wavelength sweeping range, and the resolution is higher as the wavelength sweeping range is wider. Therefore, a broadband wavelength sweeping light source is desired to be obtained.

One of wavelength sweeping light sources applicable to SS-OCT is a vertical-cavity surface emitting laser (VCSEL) providing a variable oscillation wavelength by changing a resonant cavity length by moving a reflecting mirror using a technique of Micro-Electro-Mechanical Systems (MEMS), which is discussed in "Surface micromachined tunable 1.55 $\mu$m-VCSEL with 102 nm continuous single-mode tuning", Optics Express, vol. 19, 2011, pp. 17336-17343.

Further, Japanese Patent Application Laid-Open No. 2005-183871 discusses a surface emitting laser including two light emission regions formed on a chip. In this surface emitting laser, an upper reflector layer and a lower reflector layer are provided on both sides of an active layer to constitute a light resonant cavity, and air gaps having a different gap length are provided in the vertical direction for obtaining a different oscillation wavelength for each air gap.

According to "Surface micromachined tunable 1.55 $\mu$m-VCSEL with 102 nm continuous single-mode tuning" Optics Express, vol. 19, 2011, pp. 17336-17343, a free spectral range (FSR) is one of factors limiting a wavelength sweeping range of a variable wavelength surface emitting laser (VCSEL).

Also, the FSR is determined by a resonant cavity length L and a wavelength $\lambda$ of a variable wavelength VCSEL as expressed in Formula 1. The resonant cavity length L is expressed in Formula 2 where q is an order of a longitudinal mode of a resonant wavelength.

$$FSR = \frac{\lambda^2}{2L + \lambda} \qquad \text{...Formula 1}$$

$$L = \frac{q\lambda}{2} \qquad \text{...Formula 2}$$

In other words, when an order q of a longitudinal mode and a wavelength $\lambda$ to be oscillated are determined, the resonant cavity length L is determined, thereby determining the FSR.

For a resonant cavity which can oscillate in a wavelength range wider than the FSR, a simultaneous oscillation in a plurality of longitudinal modes or an unstable oscillation state between longitudinal modes may occur.

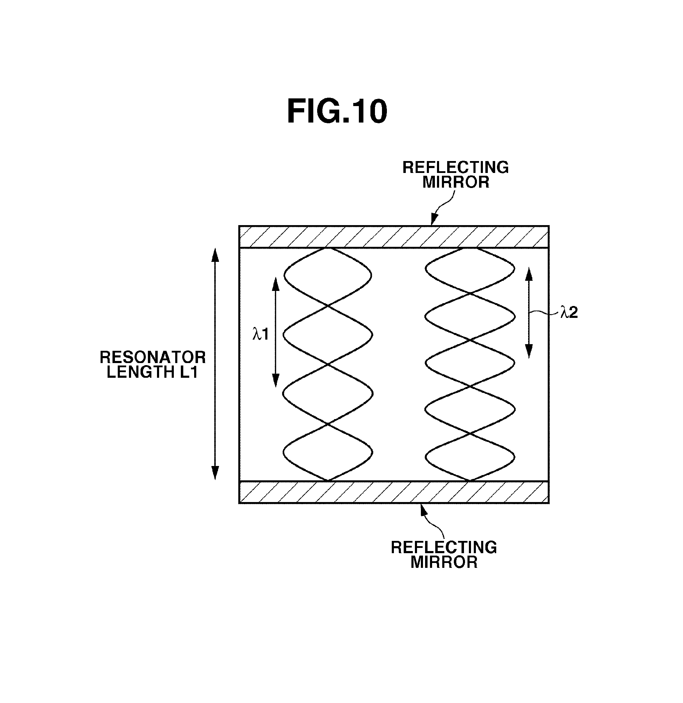

For example, a resonant cavity having a fixed resonant cavity length $L_1$ between a pair of reflecting mirrors as illustrated in Fig. 10 can work as a resonant cavity of q = 4 when a wavelength is $\lambda_1$, and work as a resonant cavity of q = 5 when a wavelength is $\lambda_2$. In such a resonant cavity, when a gain band of an active layer exists in both of the wavelengths, a simultaneous oscillation of $\lambda_1$ and $\lambda_2$, or an unstable oscillation state may occur.

The FSR can be broadened by decreasing a resonant cavity length L, making it possible to suppress a simultaneous oscillation in a plurality of longitudinal modes or an unstable oscillation state between longitudinal modes. However, a resonant cavity length tends to increase when a current injection method is to be used as a method of exciting a variable wavelength VCSEL, since layers should be configured to include a contact layer and a current diffusion layer necessary for current injection. For a larger resonant cavity length, the FSR is narrower, a wavelength sweeping range becomes smaller.

Japanese Patent Application Laid-Open No. 2005-183871 discusses a surface emitting laser, in which a plurality of different air gaps is provided to obtain a different oscillation wavelength for each air gap. However, this is intended for improving a manufacturing yield, and no focus is made on broadening of a wavelength sweeping range.

SUMMARY OF THE INVENTION

The present invention is directed to a variable wavelength VCSEL capable of sweeping a wavelength in a broad range.

According to an aspect of the present invention, there is provided a surface emitting laser as specified in claims 1 to 17, and 21. According to a second aspect of the present invention, there is provided a light source device as specified in clam 18. According to a third aspect of the present invention, there is provided a method for driving the light source device as specified in clam 19. According to a fourth aspect of the present invention, there is provided an optical coherence tomographic imaging apparatus as specified in clam 20.

The surface emitting laser according to the present invention has resonant cavity lengths with which one of the first laser and the second laser oscillates in nth order (n is an integer of 1 or more) of a longitudinal mode, and the other oscillates in the (n + 1)th order of a longitudinal mode. Therefore, the two lasers can be oscillated in two different orders, which are different from each other by one order, of a longitudinal mode. Further, since oscillation wavelength bands of the two lasers overlap in certain regions, a broad wavelength sweeping range can be obtained by changing the resonant cavity lengths of the two lasers. The broad wavelength sweeping range extends from a short wavelength side and to a long wavelength side with oscillation wavelengths overlapping with a one-order difference of an oscillation longitudinal mode in the center.

Further features of the present invention will become apparent from the following detailed description of exemplary embodiments with reference to the attached drawings.

BRIEF DESCRIPTION OF THE DRAWINGS

Fig. 1 is a schematic diagram illustrating an example of a surface emitting laser according to an exemplary embodiment of the present invention.

Fig. 2 is a graph illustrating a relationship among an order of a longitudinal mode of a laser, a resonant cavity length, and an oscillation wavelength according to an exemplary embodiment of the present invention.

Fig. 3 is a schematic diagram illustrating a surface emitting laser according to a first exemplary embodiment.

Fig. 4 is a schematic diagram illustrating an oscillation wavelength range of a laser and a reflection band of a reflecting mirror according to the first exemplary embodiment and a second exemplary embodiment.

Fig. 5 is a schematic diagram illustrating a driving timing of a surface emitting laser according to a third exemplary embodiment.

Fig. 6 is a graph illustrating a gain spectrum of an active layer used in lasers according to the first to fourth exemplary embodiments.

Fig. 7 is a schematic diagram illustrating an SS-OCT apparatus according to a fifth exemplary embodiment.

Fig. 8 is a schematic diagram illustrating a driving timing of a surface emitting laser used in the fifth exemplary embodiment.

Figs. 9A and 9B are schematic diagrams illustrating an example of a coupler for coupling light emitted from a surface emitting laser according to an exemplary embodiment of the present invention.

Fig. 10 is a schematic diagram illustrating a state of a longitudinal mode produced inside a light resonant cavity including a pair of reflecting mirrors.

DESCRIPTION OF THE EMBODIMENTS

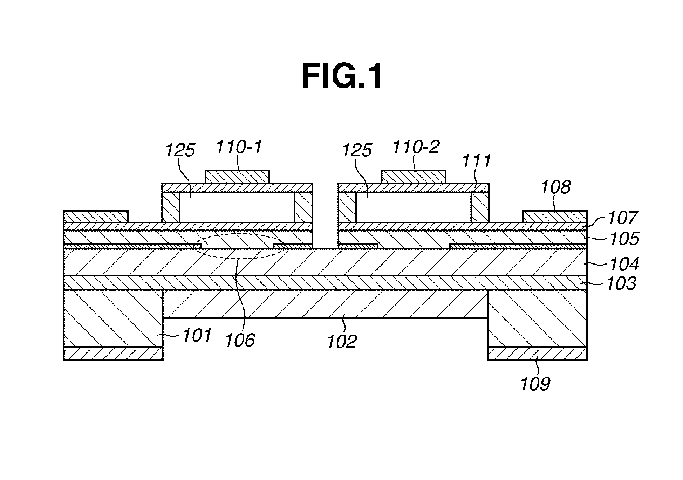

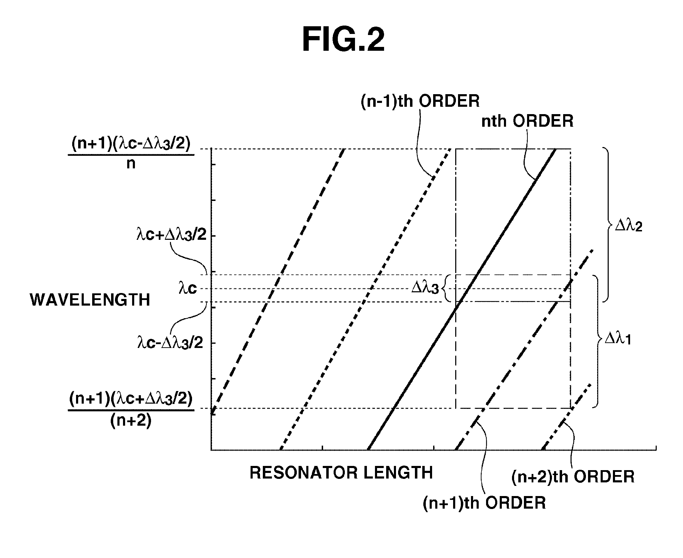

Exemplary embodiments of the present invention will be described below with reference to Figs. 1 and 2.

Fig. 1 is a schematic diagram illustrating an example of a surface emitting laser according to an exemplary embodiment of the present invention.

The surface emitting laser illustrated in Fig. 1 includes a light resonant cavity including a pair of reflecting mirrors, that is, an upper reflecting mirror 110 and a lower reflecting mirror 102, and includes a semiconductor layer, that is, an active layer 104 emitting light and arranged inside the light resonant cavity. As for the surface emitting laser, an oscillation wavelength of light can be varied by displacing the location of the reflecting mirror in the thickness direction of the semiconductor layer to thereby change a resonant cavity length.

The surface emitting laser includes a plurality of pairs of reflecting mirrors sharing the active layer 104, i.e., the semiconductor layer emitting light to constitute a first laser and a second laser.

A plurality of pairs of reflecting mirrors includes a pair consisting of an upper reflecting mirror 110-1 and the lower reflecting mirror 102, and a pair consisting of an upper reflecting mirror 110-2 and the lower reflecting mirror 102.

Further, one of the first laser and the second laser has a resonant cavity length for oscillation in nth order (n is an integer of 1 or more) of a longitudinal mode, and the other has a resonant cavity length for oscillation in the (n + 1) th order of a longitudinal mode. An oscillation wavelength band of the first laser and an oscillation wavelength band of the second laser are different. Furthermore, not all but a portion of the oscillation wavelength band of the first laser and the oscillation wavelength band of the second laser may preferably overlap. In the present exemplary embodiment, an oscillation wavelength band of a laser, or a wavelength band of oscillating light is a wavelength band in which the laser can oscillate. Therefore, an actual wavelength band oscillated by driving a laser may be narrower than the wavelength band described above.

The above issue will be described below. First, constituent portions of the surface emitting laser illustrated in Fig. 1 will be described in brief.

In Fig. 1, a substrate 101 is, for example, a GaAs substrate of a second conductivity type, and the lower reflecting mirror 102 is formed of a dielectric multilayered film or the like and shared among a plurality of surface emitting lasers.

A lower spacer layer 103 of a first conductivity type is formed of, for example, AlGaAs, an active layer 104 is formed of a quantum well of InGaAs or the like, and an upper spacer layer 105 of the second conductivity type is formed of, for example, AlGaAs.

A current confinement portion 106 is formed by selective oxidation or the like, a contact layer 107 is formed of GaAs or the like, and electrodes 108 and 109 are used for current injection.

The upper reflecting mirrors 110-1 and 110-2 are respectively formed of a dielectric multilayered film or the like, and a support member 111 is formed of GaAs, Si, or the like, and supports the upper reflecting mirror 110.

The upper reflecting mirror 110 supported by the support member 111 is formed above the contact layer 107, without touching (separated from) the contact layer 107. An air gap 125 is formed between the upper reflecting mirror 110 and the contact layer 107, and the upper reflecting mirror 110 can be displaced in the vertical direction (in the thickness direction of the active layer 104).

The lower reflecting mirror 102 is formed in the portion where the substrate 101 is removed as illustrated in Fig. 1, and extends through regions where the two surface emitting lasers respectively exist, to function as a lower reflecting mirror of the two surface emitting lasers.

The respective semiconductor layers constituting the lower spacer layer 103, the active layer 104, the upper spacer layer 105, and the contact layer 107 are formed together on the substrate 101, to constitute the two surface emitting lasers having the same configuration.

Current injection is performed by flowing current between the electrode 109 formed in contact with the GaAs substrate 101 of the second conductivity type and the electrode 108 formed in contact with the contact layer 107 of the first conductivity type to carry out radiative recombination in the active layer through the current confinement portion 106, thereby obtaining light emission.

With the two surface emitting lasers including the lower reflecting mirror and the semiconductor layers such as the active layer in common as described above, the band cannot be broadened wider than the wavelength range limited by the free spectral range (FSR) determined by the resonant cavity length.

To broaden the band wider than the wavelength range limited by the FSR determined by the resonant cavity length with a single device, in the present exemplary embodiment, one of the first laser and the second laser has a resonant cavity length for oscillation in nth order (n is an integer of 1 or more) of a longitudinal mode, and the other has a resonant cavity length for oscillation in the (n + 1)th order of a longitudinal mode. Further, in the present exemplary embodiment, the oscillation wavelength band of the first laser and the oscillation wavelength band of the second laser are different.

For a surface emitting laser having a configuration in which an oscillated wavelength is varied by changing a resonant cavity length, when a plurality of longitudinal modes satisfies a resonance condition, an oscillation wavelength becomes unstable, or a plurality of wavelengths is oscillated simultaneously.

Therefore, a single longitudinal mode may be desirably used for a single surface emitting laser. Particularly, for a variable wavelength laser used for an SS-OCT apparatus, the SS-OCT apparatus does not have a discrimination mechanism for a wavelength such as a spectroscope, and a timing of obtaining a signal is determined in synchronization with a movement of the support member 111 to estimate a wavelength. Therefore, when a plurality of wavelengths is simultaneously emitted from a light source, an interference signal caused by the plurality of wavelengths is input into a detector, which causes a problem.

An example of a specific method for determining an oscillation wavelength range and a resonant cavity length of a surface emitting laser, and a band in which wavelength bands oscillated by two surface emitting lasers overlap in the present exemplary embodiment, will be described below.

In an SS-OCT apparatus, since an interference signal is obtained at the interval of a certain wave number, when a wavelength band with no laser light output is produced among a plurality of surface emitting lasers, a discontinuity and a lack of data occur in measured data of an interference signal, which causes a problem. Therefore, it is important to eliminate a gap of an oscillation wavelength between the surface emitting lasers by enabling the plurality of surface emitting laser to oscillate with the same wavelength. A method for determining oscillation wavelength bands of the first laser and the second laser will be described below with reference to Fig. 2.

Fig. 2 is a graph illustrating a resonant cavity length and a wavelength satisfying a resonance condition at the resonant cavity length for each order of a longitudinal mode.

$\Delta\lambda_3$ is a wavelength bandwidth of overlapping oscillation wavelengths of the two surface emitting lasers (first laser and second laser), and a center wavelength $\lambda_c$ of the overlapping wavelength band is determined. By broadening the overlapping range to some extent, a gap of wavelength between the lasers, which may be created by an error occurring during production or driving of a surface emitting laser, can be suppressed.

Of the two surface emitting lasers, the surface emitting laser (first laser) with an oscillation wavelength of a shorter wavelength oscillates with a wavelength of $\lambda_1$, and the surface emitting laser (second laser) with an oscillation wavelength of a longer wavelength oscillates with a wavelength of $\lambda_2$. $\lambda_{1min}$ and $\lambda_{1max}$ are a lower limit and an upper limit of the oscillation wavelength band of the first laser, respectively, and $\lambda_{2min}$ and $\lambda_{2max}$ are a lower limit and an upper limit of the oscillation wavelength band of the second laser, respectively. The oscillation wavelength band of the first laser and the oscillation wavelength band of the second laser are different when a formula, $\lambda_{1min} < \lambda_{2min} \leq \lambda_{1max} < \lambda_{2max}$, is satisfied. In Fig. 2, a formula, $\lambda_{1min} < \lambda_{2min} < \lambda_{1max} < \lambda_{2max}$, is satisfied, which means that the oscillation wavelength band of the first laser and the oscillation wavelength band of the second laser overlap in part.

When the two surface emitting lasers oscillate with orders of a longitudinal mode which are different from each other by one order (nth order and (n + 1)th order), and in a single longitudinal mode, a range of wavelength $\lambda_1$ oscillated by the surface emitting laser (the first laser) having a shorter oscillation wavelength satisfies Formula 3. The range of $\lambda_1$, is referred to as a wavelength band of the first laser, and the width of the band is determined as $\Delta\lambda_1$ (= $\lambda_{1max}$ - $\lambda_{1min}$). The leftmost side of Formula 3 corresponds to $\lambda_{1min}$ and the rightmost side of Formula 3 corresponds to $\lambda_{1max}$.

$$\frac{(n + 1)\,(\lambda_c + \Delta\lambda_3/2)}{(n + 2)} < \lambda_1 < \lambda_c + \Delta\lambda_3/2 \qquad \text{...Formula 3}$$

Further, a range of wavelength $\lambda_2$ (wavelength band) oscillated by the surface emitting laser (the second laser) having a longer oscillation wavelength satisfies Formula 4. The range of $\lambda_2$ is referred to as a wavelength band of the second laser, and the width of the band is determined as $\Delta\lambda_2$ (= $\lambda_{2max}$ - $\lambda_{2min}$). The leftmost side of Formula 4 corresponds to $\lambda_{2min}$ and the rightmost side of Formula 4 corresponds to $\lambda_{2max}$.

$$\lambda_c - \Delta\lambda_3/2 < \lambda_2 < \frac{(n + 1)\,(\lambda_c - \Delta\lambda_3/2)}{n} \qquad \text{...Formula 4}$$

Each surface emitting laser oscillates in a single longitudinal mode in these ranges.

The above formulas represent the range where different longitudinal modes do not exist within the wavelength band of $\lambda_2$, when oscillated in nth order of a longitudinal mode.

In other words, a longitudinal mode of (n + 1)th order does not exist in the longer wavelength side, and a longitudinal mode of (n - 1)th order does not exist in the shorter wavelength side.

Since the lower limit of the wavelength band of $\lambda_2$ has been already determined, the upper limit of the wavelength band of $\lambda_2$ is to be determined. The upper limit is determined according to the FSR, that is, the difference in wavelength of a longitudinal mode between (n - 1) th order or (n + 1) th order and nth order.

The upper limit of $\lambda_2$ is determined based on a smaller difference in wavelength from among the difference in wavelength between the lower limit of $\lambda_2$ and the oscillation wavelength in the longitudinal mode of the (n-1)th order with the same resonant cavity length as that corresponding to the lower limit of $\lambda_2$, and the difference in wavelength between the lower limit of $\lambda_2$ and the oscillation wavelength in the longitudinal mode of the nth order corresponding to the resonant cavity length of the longitudinal mode of the (n+1)the order with the same wave length as the lower limit of $\lambda_2$. Specifically, if the difference in wavelength between the lower limit of $\lambda_2$ and the oscillation wavelength in the longitudinal mode of the (n-1)th order with the same resonant cavity length as that corresponding to the lower limit of $\lambda_2$ is narrow, the upper limit of $\lambda_2$ is equal to the value as that in the longitudinal mode of (n-1)th order with the same resonant cavity length as that corresponding to the lower limit of $\lambda_2$. On the other hand, if the difference in wavelength between the lower limit of $\lambda_2$ and the oscillation wavelength in the longitudinal mode of the nth order corresponding to the resonant cavity length in the longitudinal mode of (n+1)the order with the same wavelength as the lower limit of $\lambda_2$ is narrow, the upper limit of $\lambda_2$ is equal to the value of the oscillation wavelength in the longitudinal mode of nth order corresponding to the resonant cavity length of the longitudinal mode of (n+1)th order with the same oscillation wavelength as the lower limit of $\lambda_2$. For the upper limit and the lower limit of $\lambda_1$, the wavelength range is limited in a similar manner.

Consequently, the wavelength bandwidths $\Delta\lambda_1$ and $\Delta\lambda_2$ are smaller than the FSR since an oscillation is performed in a single longitudinal mode.

Further, to surely achieve a broad wavelength sweeping in a range wider than the wavelength range limited by the FSR determined by a resonant cavity length, which is an object of the present invention, $(\Delta\lambda_1 + \Delta\lambda_2 - \Delta\lambda_3)$, the range determined by the lower limit of the wavelength range of $\lambda_1$ and the upper limit of the wavelength range of $\lambda_2$, may preferably be preferably determined to be wider than the FSR.

Therefore, two formulas expressed below may preferably be satisfied.

$$\Delta\lambda_1 \; < \; FSR_1 \; < \; \Delta\lambda_1 \; + \; \Delta\lambda_2 \; - \; \Delta\lambda_3 \qquad \text{Formula 5}$$

$$\Delta\lambda_2 \; < \; FSR_2 \; < \; \Delta\lambda_1 \; + \; \Delta\lambda_2 \; - \; \Delta\lambda_3 \qquad \text{Formula 6}$$

$FSR_1$, is the FSR of the first laser, and $FSR_2$ is the FSR of the second laser. $\Delta\lambda_1$ is a wavelength bandwidth of light oscillated by the first laser, $\Delta\lambda_2$ is a wavelength bandwidth of light oscillated by the second laser, and $\Delta\lambda_3$ is a wavelength range width in which $\Delta\lambda_1$ and $\Delta\lambda_2$ overlap.

Formula 5 and 6 can be expressed in forms of Formula 5'and 6' by using $\lambda_{1max}$, $\lambda_{1min}$, $\lambda_{2max}$, and $\lambda_{2min}$.

$$\lambda_{1max} \; - \; \lambda_{1min} \; < \; FSR_1 \; < \; \lambda_{2max} \; - \; \lambda_{1min} \qquad \text{Formula 5'}$$

$$\lambda_{2max} \; - \; \lambda_{2min} \; < \; FSR_2 \; < \; \lambda_{2max} \; - \; \lambda_{1min} \qquad \text{Formula 6'}$$

There are some methods that restrain oscillation of the surface emitting laser in each wavelength of the upper limit and the lower limit.

One such method is to restrict a reflection band of a pair of reflecting mirrors constituting a resonant cavity of a surface emitting laser.

Since the volume of an active layer of a surface emitting laser is small, it is difficult to have a large gain unlike an edge emitting laser. For this reason, 99% or more reflectivity is generally required for a reflecting mirror of a surface emitting laser.

By limiting a wavelength range having the high reflectivity, an oscillatable range can be determined. For example, an oscillatable wavelength range can be limited by providing reflectivity of 99% or more in the wavelength band between an upper limit and a lower limit, and reflectivity of less than 99% outside the wavelength band.

According to the present exemplary embodiment, a lower reflecting mirror may preferably be shared among a plurality of surface emitting lasers, which may contribute to reducing cost. On the other hand, in the wavelength band in which oscillatable wavelengths overlap, a reflection band should be limited by a movable reflecting mirror to add limitation.

For example, a reflection band of a movable reflecting mirror may be used to limit an upper limit and a lower limit.

Further, while limiting an oscillatable wavelength band by a movable reflecting mirror in the region where wavelength bands overlap, the other limitation (an upper limit, when a lower limit of a surface emitting laser is included in an overlapping wavelength band; or a lower limit, when an upper limit of a surface emitting laser is included in an overlapping wavelength band) may be provided by a lower reflecting mirror to limit the oscillatable range. Consequently, the wavelength range in which both the upper reflecting mirror and the lower reflecting mirror have a reflectivity of 99% or more is an oscillatable wavelength band.

For example, a reflectivity of an upper reflecting mirror may preferably be 99% or more within a wavelength band of each laser, and a reflectivity of a lower reflecting mirror may preferably be 99% or more within a wavelength band of each laser.

Another method may be employed, in which a limitation is added to an oscillation wavelength range of each surface emitting laser by switching on/off of current injection to each surface emitting laser when a movable reflecting mirror is displaced to adjust a resonant cavity length to a wavelength band to be oscillated.

A plurality of the surface emitting lasers to which a limitation to an oscillation wavelength is added as described above can be aligned to form a surface emitting laser capable of wavelength sweeping in the broad wavelength range free of limitation by the FSR of a resonant cavity. Since an active layer and a lower reflecting mirror are shared among a plurality of surface emitting lasers, a surface emitting laser having a broad wavelength sweeping range can be formed at low cost.

The present exemplary embodiment will be described below in more detail referring to specific exemplary embodiments.

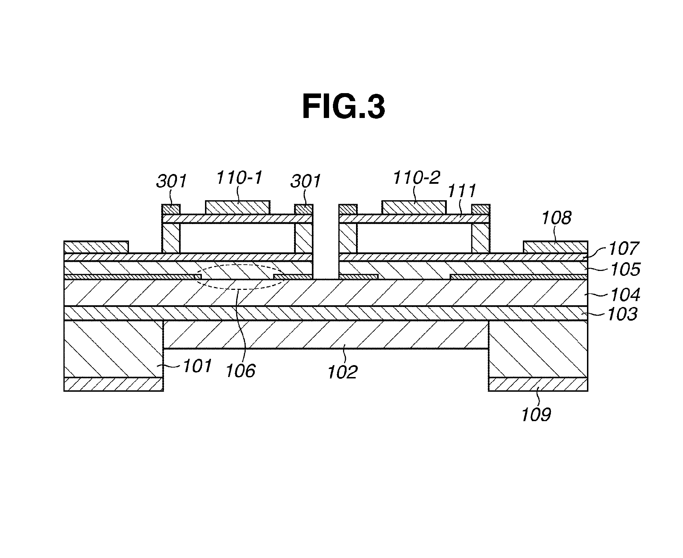

Referring to Fig. 3, a surface emitting laser of the present exemplary embodiment will be described.

In the present exemplary embodiment, an oscillatable range of a surface emitting laser is restricted by a reflection band of a movable reflecting mirror, and two surface emitting lasers having different oscillatable ranges are provided.

The surface emitting laser illustrated in Fig. 3 includes a first substrate 101 on which an active layer 104, spacer layers 103 and 105, and a contact layer 107 are formed.

In the region of a back side of the first substrate 101 in which a surface emitting laser is formed, a substrate is removed and a dielectric multilayered film is formed to provide a lower reflecting mirror 102. Two upper reflecting mirrors 110-1 and 110-2 are formed above the contact layer 107 of the first substrate 101 with an air gap therebetween.

The upper reflecting mirrors 110-1 and 110-2 are each supported by an elastic beam (support member 111) and displaceable in a thickness direction of the active layer 104 which is a semiconductor layer (a direction perpendicular to the substrate). The upper reflecting mirror 110 includes a dielectric multilayered-film reflecting mirror, for example. A first light resonant cavity includes the upper reflecting mirror 110-1 and the lower reflecting mirror 102, and a first surface emitting laser includes the active layer 104 located inside the first light resonant cavity. A second light resonant cavity includes the upper reflecting mirror 110-2 and the lower reflecting mirror 102, and a second surface emitting laser includes the active layer 104 located inside the second light resonant cavity.

For example, when the center wavelength $\lambda_c$ of the oscillation wavelength band of the two surface emitting lasers is 850 nm, an overlapping oscillation wavelength bandwidth $\Delta\lambda_3$ is 20 nm, and an order n of a longitudinal mode is 12, each oscillatable range of the first surface emitting laser in the short wavelength side and the second surface emitting laser in the long wavelength side can be determined as described in the present exemplary embodiment.

The wavelength band of the oscillation wavelength $\lambda_1$, of the first surface emitting laser is:

$$798.5 \text{ nm} < \lambda_1 < 860 \text{ nm}.$$

The wavelength band of the oscillation wavelength $\lambda_2$ of the second surface emitting laser is:

$$840 \text{ nm} < \lambda_2 < 910 \text{ nm}.$$

To achieve the oscillation wavelength band, each of the upper reflecting mirrors of the first surface emitting laser and the second surface emitting laser is designed to have a reflection band with reflectivity of 99% or more.

For example, a multilayered-film reflecting mirror formed of $SiO_2$ and SiON, which are materials having no light absorbance in the wavelength range mentioned above, may be used. For example, when a refractive index of $SiO_2$ is 1.45, a refractive index of SiON is 1.77, and 17 pairs are formed with a thickness of a quarter of 828 nm wavelength, a reflection band with reflectivity of 99% or more can be obtained within the wavelength band of the first surface emitting laser.

Further, as for the upper reflecting mirror, 17 pairs are formed with a thickness of a quarter of 874 nm wavelength with $SiO_2$ having a refractive index of 1.45 and SiON having a refractive index of 1.77 to obtain a wavelength band of the second surface emitting laser.

In this manner, an oscillatable range can be determined by the upper reflecting mirrors of the first surface emitting laser and the second surface emitting laser.

Further, as for the dielectric multilayered film 102 used as the lower reflecting mirror, 25 pairs are formed with a thickness of a quarter of 850 nm wavelength with $SiO_2$ having a refractive index of 1.45 and SiON having a refractive index of 2.00, thereby obtaining reflectivity higher than that of the upper reflecting mirror throughout the wavelength band of the first surface emitting laser and the second surface emitting laser.

By providing high reflectivity of the lower reflecting mirror compared to that of the upper reflecting mirror, as described above, a large optical output can be obtained from the upper reflecting mirror side.

Since an order n of a longitudinal mode is determined to be 12, a resonant cavity length can be determined by Formula 7. In Formula 7, q represents an order and $\lambda_q$ represents a resonant wavelength at the order of q.

$$L = \frac{q\,\lambda_q}{2} \qquad \text{...Formula 7}$$

In the case of the second surface emitting laser using 12th order of a longitudinal mode, the range of resonant cavity length $L_2$ is determined by a wavelength band of $\lambda_2$ and is: 5040 nm < $L_2$ < 5460 nm.

In the case of the first surface emitting laser using (n + 1)th order of a longitudinal mode, that is, 13th order of a longitudinal mode, the range of resonant cavity length $L_1$ is determined by a wavelength range of $\lambda_1$ and is:

$$5190.25 \text{ nm} < L_1 < 5590 \text{ nm.}$$

By driving the movable upper reflecting mirrors 110-1 and 110-2 to provide a resonant cavity length within the ranges described above, light having an initially determined wavelength range is emitted from the first surface emitting laser and the second surface emitting laser.

Even when the movable upper reflecting mirror is moved farther so that the length would be larger than the resonant cavity length, an oscillatable wavelength range is determined by limiting the reflection band of the upper reflecting mirror. Therefore, continuous wavelength sweeping can be performed without change in a longitudinal mode.

For example, by applying voltage between a driving electrode 301 and an electrode 108 to produce electrostatic attraction between the support member 111 and the contact layer 107, the upper reflecting mirror 110 can be displaced to the substrate side.

In this case, the upper reflecting mirror 110 can initially be arranged to create a maximum resonant cavity length of 5590 nm, and then moved to the substrate side to obtain a shorter resonant cavity length.

According to the present exemplary embodiment, it may be preferable that an order n of a longitudinal mode is generally be within a range from 5 to 30 considering an oscillation wavelength and a resonant cavity length to be obtained.

Further, an overlapping oscillation wavelength bandwidth $\Delta\lambda_3$ is generally within a range from 0 nm to 70 nm, or may preferably be within a range from 5 nm to 40 nm from a viewpoint of performing a broad wavelength sweeping.

The resonant cavity length described above is determined by the sum of optical path lengths at four locations forming the resonant cavity.

The first length is a length of an air gap. This is the length of the gap formed between the upper reflecting mirror and the semiconductor layer including contact layers. The gap varies by driving the upper reflecting mirror.

The second length is a light penetration length into the dielectric multilayered film constituting the upper reflecting mirror. An approximate value of the penetration length Lpen is determined by refractive indexes (n1, n2) and thicknesses ($L_1$, $L_2$) of materials constituting the dielectric multilayered film by Formula 8 expressed below.

$$L\,p\,e\,n = \frac{(L1+L2)}{4}\frac{n1+n2}{n1-n2} \qquad \text{......Formula 8.}$$

Formula 8 is discussed in "Vertical-Cavity Surface-Emitting Lasers" (Cambridge University Press) edited by Larry. Coldren, et al.

Using the formula 8, an approximate value of a penetration length at a center wavelength of the reflection band of the dielectric multilayered film can be calculated. However, in the present exemplary embodiment, the dielectric multilayered film is used as a reflecting mirror for a wavelength other than the center wavelength. Therefore, the penetration length for each wavelength varies.

The third length is determined by a thickness of a semiconductor layer such as the contact layer and the active layer, and a refractive index of a material of such a layer.

The fourth length is a light penetration length into the dielectric multilayered film constituting the lower reflecting mirror. This length can be expressed in a similar manner to the second length, which is the penetration length into the upper reflecting mirror.

In the present exemplary embodiment, the resonant cavity is configured so that the optical path length is 5590 nm, where the optical path length is the total sum of the penetration lengths into the upper and lower reflecting mirrors, the optical path length of the semiconductor layer, and the length of the air gap.

For example, on the upper surface of the substrate, a contact layer, a current diffusion layer, a current narrowing layer, an active layer, and a current diffusion layer are laminated in this order as semiconductor layers.

For example, the active layer may have a gain within a wavelength range of 780 nm to 910 nm by using $A_{10.15}Ga_{0.85}As$ in a barrier layer, and $In_{0.08}Ga_{0.92}As$ of 8 nm as a quantum well layer.

Further, by using a known compound semiconductor such as AlGaInP base, AlGaAs base, InGaAsP base, and InGaAs base, a surface emitting laser for 680 nm band, 700 nm band, 1300 nm band, or 1500 nm band can be obtained. In this case, a reflecting mirror having high reflectivity corresponding to the wavelength band should be prepared for upper and lower reflecting mirrors. The upper reflecting mirrors 110-1 and 110-2 of the first and second surface emitting lasers formed to provide the resonant cavity length as described above, can be displaced in the direction perpendicular to the substrate toward the substrate to decrease the resonant cavity length, thereby decreasing each oscillation wavelength.

By displacing the upper reflecting mirrors 110-1 and 110-2 toward the substrate side by 550 nm, the oscillatable wavelength range described above can be obtained.

In the present exemplary embodiment, a means for displacing the upper reflecting mirror is employed, in which the electrode is formed on the beam supporting the upper reflecting mirror, and electrostatic attraction is produced by applying voltage between the electrode and the contact layer. Another means for displacing the upper reflecting mirror may be employed, in which a current path having high resistance is formed on the beam supporting the upper reflecting mirror, and heat is generated by flowing an electric current through the path to produce thermal expansion of the beam to change the length of the beam. Further, in another means, the upper reflecting mirror can be displaced by using a piezoelectric member or adding an electromagnetic driving member.

In the present exemplary embodiment, the dielectric multilayered-film reflecting mirror is used as the upper reflecting mirror and the lower reflecting mirror. However, other methods can be used to constitute the reflecting mirror.

For example, High-Contrast Grating (HCG) discussed in "Single mode high-contrast subwavelength grating vertical cavity surface", by M. C. Huang, Y. Zhou, and C. J. Chang-Hasnain, APPLIED PHYSICS LETTERS 92, 171108 can be redesigned for the wavelength band of the present exemplary embodiment and be used for either or both of the upper reflecting mirror and the lower reflecting mirror.

By using the HCG for a reflecting mirror, the reflecting mirror can be made thin and light in weight. There are advantages such as an increase in a driving speed of a movable upper reflecting mirror by weight reduction.

In the present exemplary embodiment, a maximum wavelength range in which a mode hopping does not occur is used as an oscillatable wavelength band of the first and second surface emitting lasers. However, a wavelength range may be selected according to the requirement of an application to determine an oscillatable wavelength range.

For example, when a light source according to the present exemplary embodiment is used for an application requiring an oscillation wavelength bandwidth of as large as 100 nm, $\lambda_1$ and $\lambda_2$ may be determined to be values close to each other.

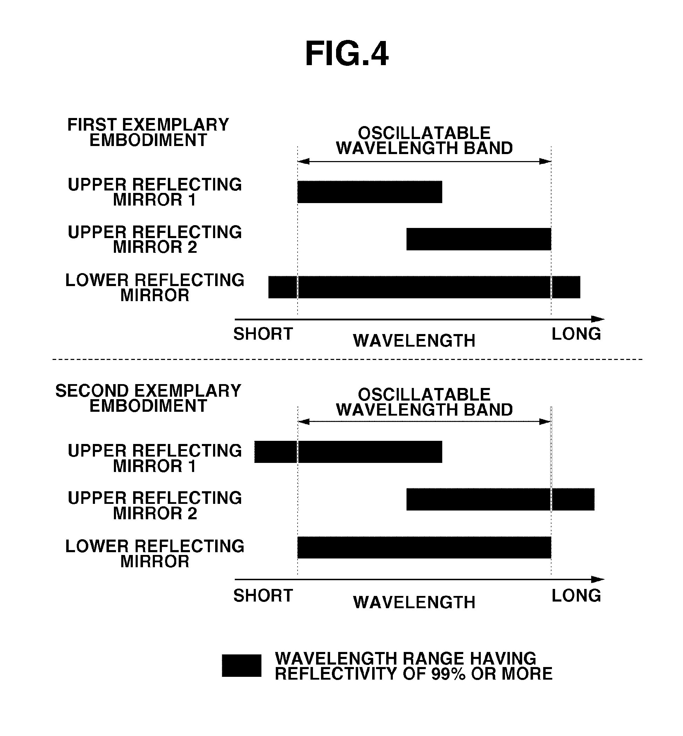

In the first exemplary embodiment, an oscillatable band of a laser is limited within a band where reflectivity of an upper reflecting mirror 110 is as high as 99% or more. The a second exemplary embodiment is distinguished in that the oscillatable range is limited by both the upper reflecting mirror 110 and the lower reflecting mirror 102. Fig. 4 is a diagram, in which a wavelength range of a reflecting mirror having a reflection band of 99% or more and an oscillatable wavelength range are compared as for the reflecting mirrors of the first exemplary embodiment and the second exemplary embodiment.

The present exemplary embodiment has the same configuration as the surface emitting laser of the first exemplary embodiment except that each band of the upper reflecting mirror and the lower reflecting mirror having a high reflectivity is different.

The lower reflecting mirror 102 shared between surface emitting lasers 1 and 2 includes a dielectric multilayered film including $SiO_2$ having a refractive index of 1.45 and SiON having a refractive index of 1.77. Each has a thickness of a quarter of 850 nm wavelength and 31 pairs thereof are laminated. Consequently, a wavelength range having reflectivity of 99% or more ranges from 799.2 nm to 907.7 nm.

The upper reflecting mirror 110-1 of the surface emitting laser 1 includes a dielectric multilayered film including $SiO_2$ having a refractive index of 1.45 and SiON having a refractive index of 1.78. Each has a thickness of a quarter of 815 nm wavelength and 20 pairs thereof are laminated. Consequently, a wavelength range having reflectivity of 99% or more ranges from 860 nm and below.

Similarly, the upper reflecting mirror 110-2 of the surface emitting laser 2 includes a dielectric multilayered film including $SiO_2$ having a refractive index of 1.45 and SiON having a refractive index of 1.78. Each has a thickness of a quarter of 885 nm wavelength and 20 pairs thereof are laminated. Consequently, a wavelength range having reflectivity of 99% or more ranges from 840 nm and above.

As described above, in the wavelength band where oscillation wavelength bands of the surface emitting lasers 1 and 2 overlap, the wavelength can be limited using the upper reflecting mirror, and the lower reflecting mirror can be used to limit the wavelength outside the oscillation wavelength band. In the present exemplary embodiment, the lower reflecting mirror is used for limitation outside the oscillation wavelength band. The shared lower reflecting mirror has a high reflectivity by layering multiple pairs of $SiO_2$/SiON to take out light from the upper reflecting mirror. Reflectivity of such dielectric multilayered-film reflecting mirror as described above decreases drastically outside the reflection band. This can apparently distinguish the limitation of wavelength of the surface emitting lasers 1 and 2.

In the first exemplary embodiment, the oscillatable bandwidth of a laser is limited within a band where reflectivity of the upper reflecting mirror is as high as 99% or more. In a third exemplary embodiment, the oscillatable band is controlled by the upper reflecting mirror and a timing of performing current injection. For this reason, the present exemplary embodiment includes a control unit for controlling a timing of performing current injection to the first laser and the second laser according to variation of a resonant cavity length of the second laser and a resonant cavity length, which changes according to the displacement of the upper reflecting mirror, of the first laser.

Specifically, the upper limit of $\lambda_1$ and the lower limit of $\lambda_2$ in the first exemplary embodiment are limited by the reflection band of the upper reflecting mirror.

As for the lower limit of $\lambda_1$ and the upper limit of $\lambda_2$ in the first exemplary embodiment, an oscillation wavelength range is limited by controlling the timing of performing current injection.

The upper reflecting mirror of the surface emitting laser 1 is displaced to vary the resonant cavity length between 5040 nm and 5590 nm.

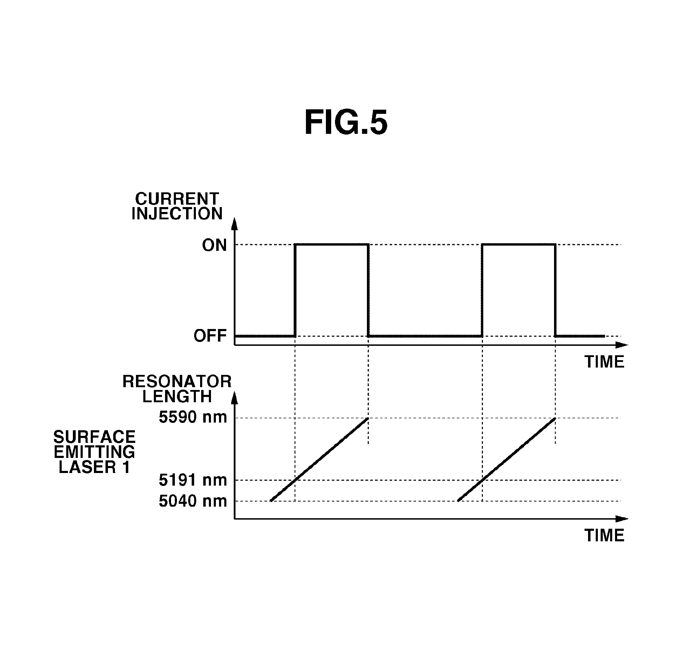

During the period, as illustrated in Fig. 5, for example, current injection is not performed when the resonant cavity length is 5040 nm or higher and less than 5191 nm, the current injection starts at the timing when the resonant cavity length is 5191 nm (oscillation wavelength of 798.6 nm), and then the current injection stops when the resonant cavity length is 5590 nm (oscillation wavelength of 860 nm).

The upper reflecting mirror of the surface emitting laser 2 is displaced in a similar manner to the surface emitting laser 1 so that the resonant cavity length varies between 5040 nm and 5590 nm. During the period, current injection is performed when the resonant cavity length is 5040 nm or higher and less than 5460 nm (corresponding to an oscillation wavelength of 840 nm or higher and less than 910 nm), and the current injection stops at the timing when the resonant cavity length is 5460 nm.

In this manner, in a wavelength band where oscillation wavelength bands of the surface emitting lasers 1 and 2 overlap, a wavelength can be limited using the upper reflecting mirror, and a wavelength outside the oscillation wavelength band can be limited by controlling the timing of current injection.

In the present exemplary embodiment, limitation is added to the oscillation wavelength band by the upper reflecting mirror and a timing control of current injection. However, limitation may be added to the oscillation wavelength solely by a timing of current injection.

In other words, current injection may be switched ON/OFF when the upper reflecting mirror moves to obtain a resonant cavity length which corresponds to the upper limit of $\lambda_1$ or the lower limit of $\lambda_2$.

In the first and second exemplary embodiments, an oscillation wavelength band is limited by a wavelength band having high reflectivity. In this method, when reflectivity of the wavelength at the boundary of an oscillation wavelength band changes gradually, the output of oscillated laser light tends to decrease gradually, which generally makes the wavelength band indistinct.

On the other hand, in the present exemplary embodiment, the oscillation wavelength band is limited by switching ON/OFF of the current injection, and it is not necessary to change reflectivity in the oscillation wavelength band. Therefore, the wavelength band can be distinctly defined by switching ON/OFF of the current injection.

In a fourth exemplary embodiment, reflectivity of the upper reflecting mirror of the surface emitting laser of the first exemplary embodiment is changed to restrain dispersion of a threshold current value.

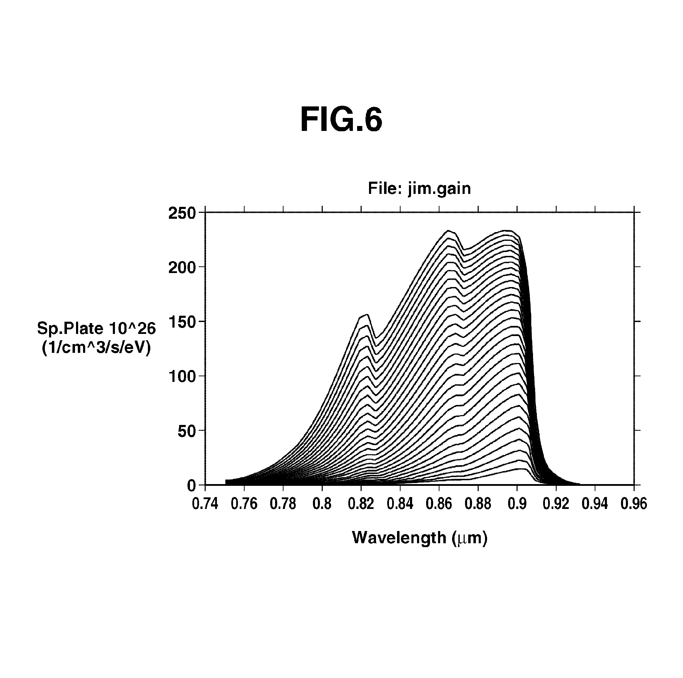

Fig. 6 illustrates the gain spectrum of the active layer employed in the surface emitting laser according to the first exemplary embodiment.

According to Fig. 6, it can be understood that gain in the short wavelength side starts to decrease from the peak at the wavelength of 870 nm. When a resonant cavity includes this type of active layers and a reflecting mirror having the same reflectivity for the entire oscillatable wavelength band, the threshold current value varies according to the values of gain.

For a wavelength with a large gain, the threshold current value is small, and for a wavelength with a small gain, the threshold current value is large. This creates a variation in the optical output.

In the first exemplary embodiment, as for the surface emitting laser 1 which oscillates in the wavelength band in the short wavelength side, the oscillatable wavelength band is determined as:

$$798.5 \text{ nm} < \lambda_1 < 860 \text{ nm}.$$

As for the surface emitting laser 2 that oscillates in the wavelength band in the long wavelength side, the oscillatable wavelength band is determined as:

$$840 \text{ nm} < \lambda_2 < 910 \text{ nm}.$$

For example, the active layer used in the first exemplary embodiment has a smaller gain in the short wavelength side than that in the long wavelength side as described above. Therefore, when the upper reflecting mirror has the same reflectivity for both wavelength sides, the threshold current value of the surface emitting laser 1 in the short wavelength side is larger.

In the present exemplary embodiment, upper reflecting mirrors of the surface emitting laser 1 and the surface emitting laser 2 have different reflectivity. For example, the number of pairs of dielectric multilayered films constituting the upper reflecting mirror of the surface emitting laser 2 is reduced to 22 pairs.

As described above, focusing on the wavelength dependence of gain of an active layer in the oscillation wavelength band of the surface emitting lasers 1 and 2, a difference in threshold current value between the two surface emitting lasers can be decreased to reduce load on a driving circuit, by providing a different value of reflectivity according to the value of gain.

An example in which a surface emitting laser according to a fifth exemplary embodiment of the present invention is used for an SS-OCT apparatus will be described.

In the present exemplary embodiment, a surface emitting laser according to the present exemplary embodiment is used as a light source of an optical coherence tomographic imaging apparatus.

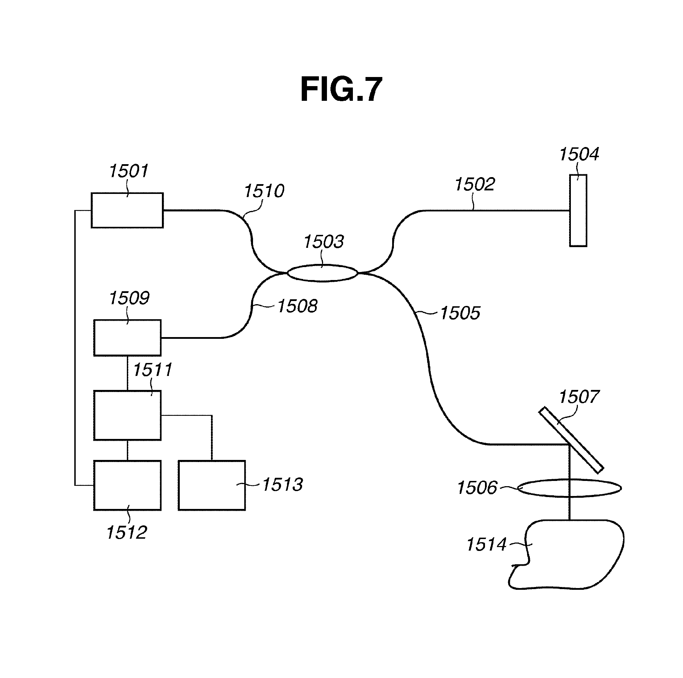

Fig. 7 is a schematic diagram illustrating an OCT apparatus according to the present exemplary embodiment.

The OCT apparatus illustrated in Fig. 7 basically includes a light source unit (variable wavelength light source 1501), an object measurement unit (irradiation position scanning mirror 1507), a reference unit (fiber 1502), an interference unit (fiber coupler 1503), a light detection unit (photodetector 1509), and an image processing unit (signal processing device 1511). The light source unit 1501 irradiates an object with light from the light source unit and transmits reflected light from the object. The reference unit (fiber 1502) irradiates a reference mirror with light and transmits reflected light from the reference mirror. The interference unit (fiber coupler 1503) produces interference between the two reflected light. The light detection unit (photodetector 1509) detects interference light obtained by the interference unit (fiber coupler 1503). The image processing unit (signal processing device 1511) processes an image (obtains a tomogram) based on the light detected by the light detection unit (photodetector 1509).

Each component will be described below.

The light source unit includes the variable wavelength light source 1501 and a light source control device 1512 for controlling the variable wavelength light source 1501. The variable wavelength light source 1501 is connected to the fiber coupler 1503, which constitutes the interference unit, via an optical fiber 1510 for light-irradiation.

The fiber coupler 1503 of the interference unit includes a type of single mode in a wavelength band of the light source, and each type of the fiber coupler includes a 3dB coupler.

A reflecting mirror 1504 is connected to a fiber 1502 for a reference light path to constitute the reference unit, and the fiber 1502 is connected to the fiber coupler 1503.

A measurement unit includes a fiber for an inspection light path 1505, an irradiation collective optical system 1506, and an irradiation position scanning mirror 1507. The fiber for an inspection light path 1505 is connected to the fiber coupler 1503. In the fiber coupler 1503, back scattered light produced inside and on the surface of an inspection object 1514, and an optical feedback from the reference unit interfere to cause interference light.

The light detection unit includes a light receiving fiber 1508 and a photodetector 1509, and introduces the interference light caused by the fiber coupler 1503 to the photodetector 1509.

The light received by the photodetector 1509 is converted into a spectrum signal by the signal processing device 1511. The Fourier transformation is performed on the spectrum signal to obtain depth information of an object (a subject to be tested).

The obtained depth information is displayed on an image output monitor 1513 as a tomogram.

The signal processing device 1511 can be constituted by a personal computer, and the image output monitor 1513 can be constituted by a display of a personal computer.

The light source unit is distinctive in the present exemplary embodiment in that the oscillation wavelength, intensity, and a time variation of the light oscillated by the variable wavelength light source 1501 are controlled by the light source control device 1512.

The light source control device 1512 is connected to the signal processing device 1511, which also controls a driving signal of the irradiation position scanning mirror 1507. The light source control device 1512 controls the variable wavelength light source 1501 in synchronization with the driving of the irradiation position scanning mirror 1507.

For example, when the surface emitting laser described in the first exemplary embodiment is used as the variable wavelength light source 1501 of the present exemplary embodiment, the variable wavelength light source 1501 is controlled in a manner described below.

The surface emitting laser according to the first exemplary embodiment includes two surface emitting lasers, i.e., the surface emitting laser 1 and the surface emitting laser 2. Since oscillation wavelength bands of the two surface emitting lasers are different, driving timings of the two surface emitting lasers need to be adjusted.

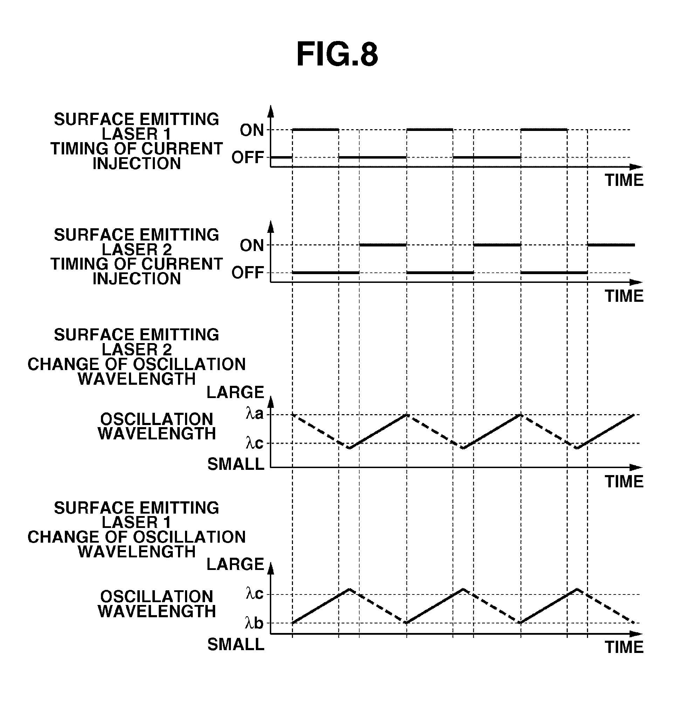

The driving timing will be described with reference to Fig. 8. In Fig. 8, the vertical axis represents the ON/OFF status of current injection or oscillation wavelength, and the horizontal axis represents time, each of which is illustrated for the surface emitting lasers 1 and 2.

As for the upper reflecting mirror, the upper reflecting mirror 101-1, that is, one of two reflecting mirrors of the surface emitting laser 1 is driven with a certain period. With the same driving period as the above certain period, and with 180 degrees phase difference, the upper reflecting mirror 101-2 of the surface emitting laser 2 is driven. The above two processes correspond respectively to a first driving step of driving one of two reflecting mirrors of a laser with a certain period, and a second driving step of driving one of two reflecting mirrors of the other laser with the same period as the first driving step and with 180 degrees phase difference from the first driving step.

To change the wavelength of an optical output from the variable wavelength light source 1501 from a short wave to a long wave, a movable reflecting mirror of the surface emitting laser 1 is driven to vary a resonant cavity length, thereby changing the oscillation wavelength from a short wavelength to a long wavelength.

First, current injection starts at the timing when the resonant cavity length is 5190.25 nm corresponding to the minimum wavelength of $\lambda_1$ which is 798.5 nm (referred to as $\lambda_b$ in Fig. 8). Then, the upper reflecting mirror moves and the current injection stops when the resonant cavity length is 5525 nm and $\lambda_c$ is 850 nm as determined in the first exemplary embodiment. This corresponds to the first current injection step in which current injection stops when the wavelength is of particular wavelength $\lambda_z$ included in overlapping wavelength range $\Delta\lambda_3$ during the first driving step. Then, at a timing when the oscillation wavelength of the surface emitting laser 2 changes from a short wavelength to a long wavelength, and when the upper reflecting mirror moves and the resonant cavity length is 5100 nm and $\lambda_c$ is 850 nm as determined in the first exemplary embodiment, current injection starts. This corresponds to the second current injection step in which current injection starts when the wavelength is of particular wavelength $\lambda_z$ during the second driving step. Consequently, each of the first and second current injection steps is performed during each period in which the direction of the change in oscillation wavelength is the same.

Then, the current injection stops at the timing when the resonant cavity length is 5460 nm corresponding to the maximum wavelength of $\lambda_2$ which is 910 nm (illustrated as $\lambda_a$ in Fig. 8).

Using this driving method, the wavelength sweeping of 111 nm can be continuously performed. The series of the driving of wavelength sweeping can be provided as a set. The set can be used as the variable wavelength light source 1501 in synchronization with driving of the irradiation position scanning mirror 1507 described above.

When the light source device described in the first exemplary embodiment is used as the variable wavelength light source 1501 of the present exemplary embodiment, tomographic image information can be obtained with high resolution in depth since the light source device can perform wavelength sweeping in a broad band. The OCT apparatus is useful for capturing a tomographic image in the fields of ophthalmology, dentistry, and dermatology. Further, when the surface emitting laser of the first exemplary embodiment is used as the light source 1501 of the present exemplary embodiment, an optical coupler, which couples light emitted from the surface emitting lasers 1 and 2, is necessary.

Then, the light coupled by the optical coupler is connected to the optical fiber 1510 for light-irradiation. That is, such device including two surface emitting lasers and an optical coupler for coupling light emitted from each laser may be considered as a light source device.

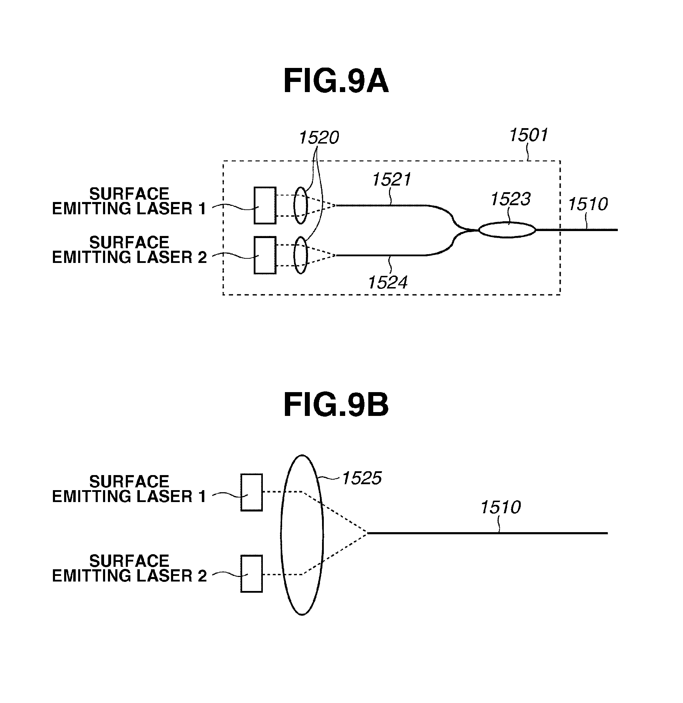

An example of the optical coupler is illustrated in Fig. 9A in which a fiber combining lens 1520, optical fibers 1521 and 1524, and a fiber coupler 1523 are combined.

Further, since the surface emitting lasers 1 and 2 can be formed on the same substrate while being very close to each other, each emitted light from the surface emitting lasers 1 and 2 may be connected to the optical fiber 1510 for light-irradiation using a combining lens 1525 as illustrated in Fig. 9B.

While the present invention has been described with reference to exemplary embodiments, it is to be understood that the invention is not limited to the disclosed exemplary embodiments. The scope of the following claims is to be accorded the broadest interpretation so as to encompass all such modifications and equivalent structures and functions. A surface emitting laser includes a first laser, and a second laser, wherein each of the first laser and the second laser includes a light resonant cavity including a pair of reflecting mirrors, and a semiconductor layer configured to emit light and arranged inside the light resonant cavity, an oscillation wavelength of light can be varied by displacing a location of the reflecting mirror in a thickness direction of the semiconductor layer, the semiconductor layer is shared by the first laser and the second laser, the first laser has a resonant cavity length for oscillating with (n + 1)th order (n is an integer of 1 or more) of a longitudinal mode, the second laser has a resonant cavity length for oscillating with nth order of a longitudinal mode, and respective wavelength bands of light oscillated by the first laser the second laser are different.

**Claims**

1.  A surface emitting laser comprising:

    a first laser; and
    a second laser,
    wherein each of the first laser and the second laser includes a light resonant cavity including a pair of reflecting mirrors, and a semiconductor layer configured to emit light and arranged inside the light resonant cavity,
    an oscillation wavelength of light can be varied by displacing a location of the reflecting mirror in a thickness direction of the semiconductor layer,
    the semiconductor layer is shared by the first laser and the second laser,
    the first laser has a resonant cavity length for oscillating with (n + 1)th order (n is an integer of 1 or more) of a longitudinal mode,
    the second laser has a resonant cavity length for oscillating with nth order of a longitudinal mode, and
    respective oscillation wavelength bands of light oscillated by the first laser the second laser are different.

2.  The surface emitting laser according to claim 1, wherein a formula expressed below is satisfied, where $\lambda_{1min}$ and $\lambda_{1max}$ are a lower limit and an upper limit of an oscillation wavelength band of the first laser, respectively, and $\lambda_{2min}$ and $\lambda_{2max}$ are a lower limit and an upper limit of an oscillation wavelength band of the second laser, respectively:

$$\lambda_{1min} < \lambda_{2min} \leq \lambda_{1max} < \lambda_{2max}.$$

3.  The surface emitting laser according to claim 1 or 2, wherein part of wavelength bands of light oscillated by the first laser and the second laser overlap.

4.  The surface emitting laser according to any one of claims 1 to 3, wherein two formulas expressed below are satisfied, where $FSR_1$, is a free spectral range of the first laser, $FSR_2$ is a free spectral range of the second laser, $\Delta\lambda_1$ is a width of a wavelength band of light oscillated by the first laser, $\Delta\lambda_2$ is a width of a wavelength band of light oscillated by the second laser, and $\Delta\lambda_3$ is a width of a range where $\Delta\lambda_1$ and $\Delta\lambda_2$ overlap:

$$\Delta\lambda_1 < FSR_1 < \Delta\lambda_1 + \Delta\lambda_2 - \Delta\lambda_3 \qquad \text{Formula 5}$$

$$\Delta\lambda_2 < FSR_2 < \Delta\lambda_1 + \Delta\lambda_2 - \Delta\lambda_3 \qquad \text{Formula 6}.$$

5.  The surface emitting laser according to any one of claims 1 to 4, wherein the wavelength $\lambda_1$ oscillated by the first laser satisfies Formula 3 expressed below, and the wavelength $\lambda_2$ oscillated by the second laser satisfies Formula 4 expressed below, where $\Delta\lambda_3$ is a width of the overlapping wavelength band and $\lambda_c$ is a center wavelength of the overlapping wavelength band:

$$\frac{(n+1)(\lambda_c+\Delta\lambda_3/2)}{(n+2)} < \lambda_1 < \lambda_c+\Delta\lambda_3/2 \qquad \text{...Formula 3}$$

$$\lambda_c-\Delta\lambda_3/2 < \lambda_2 < \frac{(n+1)(\lambda_c-\Delta\lambda_3/2)}{n} \qquad \text{...Formula 4.}$$

6. The surface emitting laser according to any one of claims 1 to 5, wherein the pair of reflecting mirrors includes an upper reflecting mirror and a lower reflecting mirror, and the upper reflecting mirror is configured to be displaceable.

7. The surface emitting laser according to claim 6, wherein a reflectivity of the upper reflecting mirror for the first laser is 99% or more within the oscillation wavelength band, and a reflectivity of the upper reflecting mirror for the second laser is 99% or more within the oscillation wavelength band..

8. The surface emitting laser according to any one of claims 6, wherein a reflectivity of the lower reflecting mirror for the first laser is 99% or more within the oscillation wavelength band, and a reflectivity of the upper reflecting mirror for the second laser is 99% or more within the oscillation wavelength band..

9. The surface emitting laser according to any one of claims 6, further comprising a control means configured to control a timing of current injection to the first laser and to the second laser in response to changes of resonant cavity lengths of the first laser and the second laser, which is caused by displacement of the upper reflecting mirror.

10. The surface emitting laser according to any one of claims 1 to 9, wherein at least one of the pair of reflecting mirrors is a reflecting mirror including an HCG.

11. The surface emitting laser according to any one of claims 1 to 10, wherein at least one of the pair of reflecting mirrors is a multilayered film reflecting mirror.

12. The surface emitting laser according to any one of claims 1 to 11, wherein a width $\Delta\lambda_3$ of an overlapping wavelength band is within a range from 0 nm to 70 nm.

13. A light source device comprising:

the surface emitting laser according to any one of claims 1 to 12; and
an optical coupler configured to couple laser light emitted respectively from the first laser and the second laser of the surface emitting laser.

14. A method for driving the light source device according to claim 13, comprising:

performing first driving of one of the two reflecting mirrors of one of the two lasers with a certain period;
performing second driving of one of the two reflecting mirrors of the other laser with the same period as the certain period, and with 180 degrees phase difference from the certain period;
stopping current injection at a particular wavelength within a range of the overlapping wavelength during the first driving; and
starting current injection at the particular wavelength during the second driving,
wherein each of the stopping current injection and the starting current injection are performed when an oscillation wavelength changes in a certain direction, which is the same for the first and second lasers.

**15.** An optical coherence tomographic imaging apparatus, comprising:

the light source device according to claim 13;
an object measurement means configured to irradiate an object with light from the light source means and transmit reflected light from the object;
a reference means configured to irradiate a reference mirror with light from the light source means and transmit reflected light from the reference mirror;
an interference means configured to cause interference between the reflected light from the object measurement means and the reflected light from the reference means;
a light detection means configured to detect interference light from the interference means; and
an image processing means configured to obtain a tomogram of the object based on the light detected by the light detection means.

# FIG.1

EP 2 701 249 A2

# FIG.2

17

# FIG.3

# FIG.4

FIRST EXEMPLARY
EMBODIMENT

OSCILLATABLE
WAVELENGTH BAND

UPPER REFLECTING
MIRROR 1

UPPER REFLECTING
MIRROR 2

LOWER REFLECTING
MIRROR

SHORT      WAVELENGTH      LONG

SECOND EXEMPLARY
EMBODIMENT

OSCILLATABLE
WAVELENGTH BAND

UPPER REFLECTING
MIRROR 1

UPPER REFLECTING
MIRROR 2

LOWER REFLECTING
MIRROR

SHORT      WAVELENGTH      LONG

WAVELENGTH RANGE HAVING
REFLECTIVITY OF 99% OR MORE

# FIG.5

CURRENT
INJECTION

ON

OFF

TIME

RESONATOR
LENGTH

SURFACE
EMITTING
LASER 1

5590 nm

5191 nm
5040 nm

TIME

# FIG.6

File: jim.gain

Sp.Plate 10^26
(1/cm^3/s/eV)

Wavelength (μm)

# FIG.7

# FIG.8

SURFACE EMITTING
LASER 1
TIMING OF CURRENT
INJECTION

ON

OFF

TIME

SURFACE EMITTING
LASER 2
TIMING OF CURRENT
INJECTION

ON

OFF

TIME

SURFACE EMITTING
LASER 2
CHANGE OF OSCILLATION
WAVELENGTH

LARGE

OSCILLATION
WAVELENGTH

$\lambda a$

$\lambda c$

SMALL

TIME

SURFACE EMITTING
LASER 1
CHANGE OF OSCILLATION
WAVELENGTH

LARGE

OSCILLATION
WAVELENGTH

$\lambda c$

$\lambda b$

SMALL

TIME

# FIG.9A

# FIG.9B

# FIG.10

REFLECTING
MIRROR

RESONATOR
LENGTH L1

λ1

λ2

REFLECTING
MIRROR

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2005183871 A

**Non-patent literature cited in the description**

- Surface micromachined tunable 1.55 $\mu$m-VCSEL with 102 nm continuous single-mode tuning. *Optics Express,* 2011, vol. 19, 17336-17343
- Vertical-Cavity Surface-Emitting Lasers. Cambridge University Press

- **M. C. HUANG ; Y. ZHOU ; C. J. CHANG-HASNAIN.** Single mode high-contrast subwavelength grating vertical cavity surface. *APPLIED PHYSICS LETTERS,* vol. 92, 171108